# EUROPEAN PATENT APPLICATION

(11) **EP 4 693 415 A1**
(43) Date of publication of application: **11.02.2026**
(21) Application number: 24779318.5
(22) Date of filing: 08.03.2024
(51) Int. Cl.: H01L 31/048, E06B 5/00, H01L 31/043, H02S 20/26, H02S 40/40

(54) **WINDOW FILM AND GLASS WINDOW**

(30) Priority: 24.03.2023 JP 2023048860
(71) Applicant: LIXIL Corporation, Tokyo 141-0033 (JP)
(72) Inventor: ISHII, Hisashi, Tokyo 141-0033 (JP)
(74) Representative: karo IP
(86) International application number: PCT/JP2024/009151
(87) International publication number: WO 2024/203187

(57) **Abstract**

A window film 11 affixed onto a glass panel 12 includes a solar cell layer 20, a heat-absorbing layer 22 that absorbs heat from the glass panel 12, and a protection layer 24 disposed as a top surface.

## Description

### TECHNICAL FIELD

The present invention relates to a window film that is affixed to a glass panel.

### BACKGROUND ART

Window films are conventionally known to be affixed to glass panels for the purpose of preventing shattering of glass, regulating solar radiation, decoration, and UV protection (see Patent Literature 1, for example).

### RELATED-ART LITERATURE

### PATENT LITERATURE

Patent Literature 1: Japanese Patent Application Laid-Open Publication No. 2014-223794

### SUMMARY OF INVENTION

### TECHNICAL PROBLEM

A glass window includes a glass panel and a frame (sash) that supports the glass panel. The outer circumferential edge of the glass panel is inserted into a groove provided in the frame and is not exposed. The exposed portion of the glass panel is directly exposed to solar radiation and absorbs heat, so as to become hot and prone to expansion. On the other hand, since the outer circumferential edge of the glass panel is inserted into the frame, it is not exposed to solar radiation and is less likely to expand. Therefore, a phenomenon called "thermal cracking" may occur in the outer circumference part of the glass panel, in which distortion occurs inside the glass, and the glass is damaged.

In particular, when a window film is affixed to the glass panel, heat is likely to remain in the glass panel due to the thermal insulation effect and reflection effect of the window film, making thermal cracking more likely.

The present invention has been made in view of such a problem, and a purpose thereof is to provide a window film capable of suppressing thermal cracking of glass panels.

### SOLUTION TO PROBLEM

To solve the problem above, a window film according to one embodiment of the present invention is a window film affixed onto a glass panel. The window film includes a solar cell layer, a heat-absorbing layer that absorbs heat from the glass panel, and a protection layer disposed as a top surface.

Another embodiment of the present invention is a glass window. The glass window includes a glass panel, a frame that supports an outer circumferential edge of the glass panel, and the abovementioned window film affixed onto an exposed surface of the glass panel.

### BRIEF DESCRIPTION OF DRAWINGS

[Fig. 1] Fig. 1 is a schematic sectional view of a glass window to which a window film according to a first embodiment is affixed.
[Fig. 2] Fig. 2 is a schematic sectional view of a glass window to which a window film according to a comparative example is affixed.
[Fig. 3] Fig. 3 is a schematic sectional view of a glass window to which a window film according to a second embodiment is affixed.
[Fig. 4] Fig. 4 is a schematic sectional view of a glass window to which a window film according to a third embodiment is affixed.
[Fig. 5] Fig. 5 is a schematic sectional view of a glass window to which a window film according to a fourth embodiment is affixed.
[Fig. 6] Fig. 6 is a schematic sectional view of a glass window to which a window film according to a fifth embodiment is affixed.

### DESCRIPTION OF EMBODIMENTS

In the following, the present invention will be described based on preferred embodiments with reference to the drawings. The configurations described below are intended for illustration for understanding of the present disclosure, and the scope of the present disclosure is defined only by the scope of the claims attached herein. Like reference characters denote like or corresponding constituting elements and members in each drawing, and repetitive description will be omitted as appropriate. Also, the dimensions of a member may be appropriately enlarged or reduced in each drawing in order to facilitate understanding. Further, in each drawing, part of a member less important in describing the embodiments may be omitted.

### First Embodiment

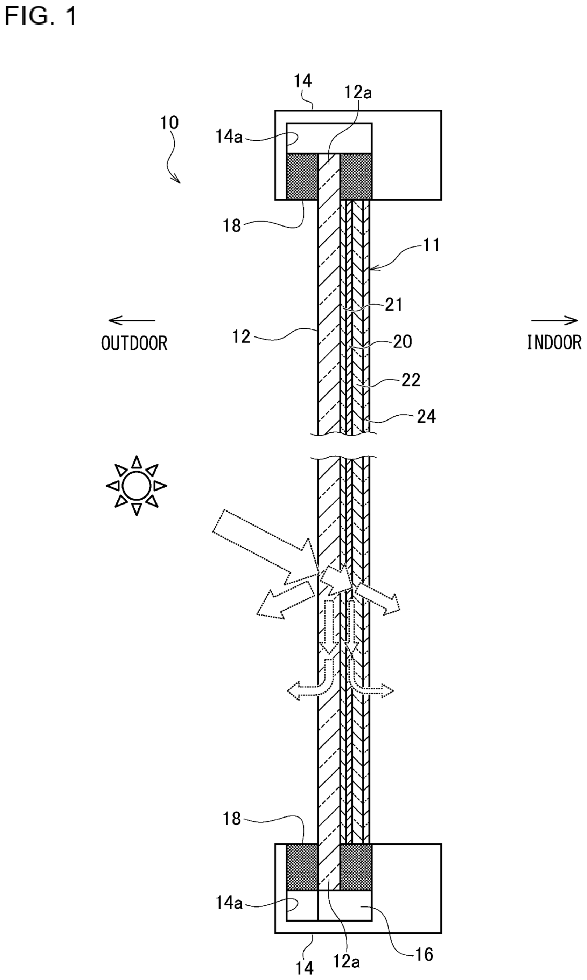

Fig. 1 is a schematic sectional view of a glass window 10 to which a window film 11 according to the first embodiment is affixed. The glass window 10 is placed in an opening or a spandrel part of a building.

As shown in Fig. 1, the glass window 10 includes a glass panel 12 and a frame 14 that supports the glass panel 12. The frame 14 includes a groove part 14a into which an outer circumferential edge 12a of the glass panel 12 is inserted. In the groove part 14a of the frame 14 on the lower side, a setting block 16 is disposed to support the load of the glass panel 12. Also, in the groove part 14a of the frame 14, a sealing material 18 is provided to fill the gaps between the glass panel 12 and the frame. Thus, in the glass window 10, the outer circumferential edge of the glass panel 12 is inserted into the frame 14 and is not exposed. The surface of the glass panel 12 other than the outer circumferential edge 12a is exposed.

The window film 11 is affixed to the exposed surface of the glass panel 12 on the indoor side. In the window film 11, a glass-side protection layer 21, a solar cell layer 20 sandwiched by encapsulants, a heat-absorbing layer 22, and a protection layer 24 are laminated in this order from the glass panel 12 side. The protection layer 24 is disposed as the top surface of the window film 11. The glass-side protection layer 21, solar cell layer 20, heat-absorbing layer 22, and protection layer 24 are integrally formed, and an adhesive layer or a bonding layer (not illustrated) is provided on the surface of the glass-side protection layer 21 on the side opposite to the solar cell layer 20 side.

The solar cell layer 20 is a layer in which multiple solar cells are arranged. The solar cells use photovoltaic effect and convert solar energy into electricity. In the solar cell layer 20, multiple solar cells are electrically connected in series and/or parallel to obtain a required predetermined voltage. The electricity generated in the solar cell layer 20 is extracted to the outside via wiring (not illustrated).

The solar cell layer 20 may be a transparent solar cell layer (high transmittance to visible light) having wavelength sensitivity in a range of the near-infrared wavelength band (e.g., 780 nm to 1200 nm). Alternatively, the solar cell layer 20 may be a transparent solar cell layer (high transmittance to visible light) having wavelength sensitivity in a range of the near-infrared and mid-infrared wavelength bands (e.g., 1400 nm to 4000 nm).

The heat-absorbing layer 22 may be a layer that has high transmittance to visible light, near-infrared light, and mid-infrared light and absorbs heat from the glass panel 12 by thermal conduction. Alternatively, the heat-absorbing layer 22 may be a layer that has high transmittance to visible light but absorbs near-infrared light and mid-infrared light and absorbs heat from the glass panel 12 by thermal conduction. Alternatively, the heat-absorbing layer 22 may be a layer that has high transmittance to visible light and near-infrared light but absorbs mid-infrared light and absorbs heat from the glass panel 12 by thermal conduction. Alternatively, the heat-absorbing layer 22 may be a layer that has high transmittance to visible light and mid-infrared light but absorbs near-infrared light and absorbs heat from the glass panel 12 by thermal conduction. The heat-absorbing layer 22 may be formed, for example, using ITO (indium tin oxide), ATO (antimony-doped tin oxide), hexaborides, or cesium-doped tungsten oxide, which have transmissivity.

The glass-side protection layer 21 and the protection layer 24 are provided to protect the entire window film 11 and may be made using transparent materials with high solar transmittance and high emissivity. The glass-side protection layer 21 and the protection layer 24 may be formed, for example, using ETFE (Ethylene Tetra Fluoro Ethylene) or PET (Polyethylene Terephthalate).

### Comparative example

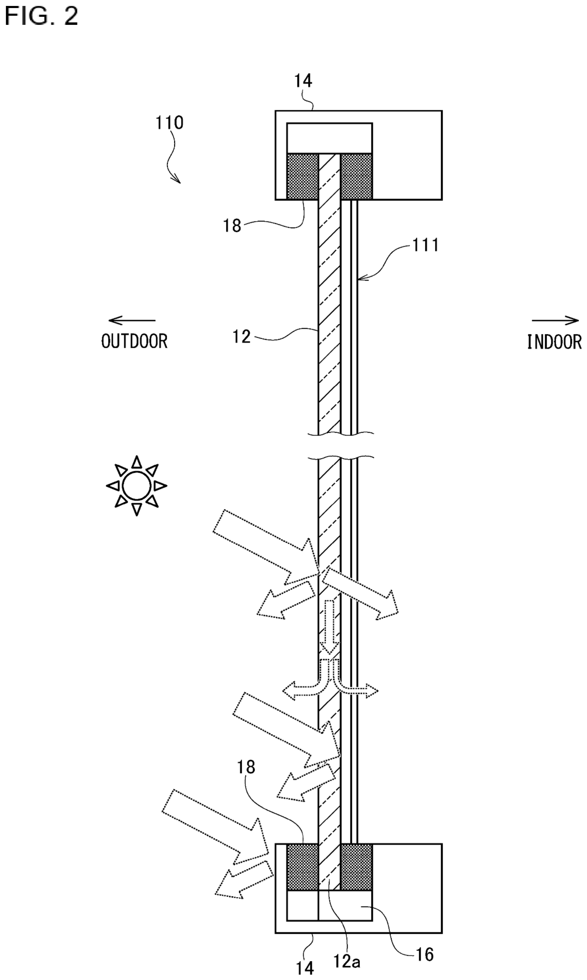

Before describing the functions of the window film 11 according to the first embodiment, a comparative example will be described. Fig. 2 is a schematic sectional view of a glass window 110 to which a window film 111 according to a comparative example is affixed. The window film 111 according to the comparative example is an ordinary window film, which suppresses light transmission and heat transfer to the indoor side.

In Fig. 2, bold arrows are used to show how solar heat is transferred through the glass window 110. The solar heat incident on the exposed portion of the glass panel 12 is partially transmitted to the indoor side, partially reflected by the glass panel 12, and partially absorbed into the glass panel 12 and transferred within the glass panel 12. The heat transferred within the glass panel 12 is partially radiated to the indoor side and partially radiated to the outdoor side. Since the window film 111 according to the comparative example acts as a thermal insulation layer, the heat radiation to the indoor side becomes smaller, and the dependence on the radiation to the outdoor side becomes higher as a route to release the heat in the glass panel 12. Accordingly, the heat is likely to remain in the glass panel 12. In addition, since the window film 111 also serves as a light-reflecting layer, the light that has penetrated the glass panel 12 is returned to the glass panel 12, which increases the amount of heat absorbed by glass panel 12. On the other hand, the outer circumferential edge 12a of the glass panel 12 is hidden within the frame 14 and is not exposed, so that the outer circumferential edge 12a is not affected by the solar heat. Accordingly, the temperature difference between the exposed portion and the unexposed portion becomes larger in the outer circumference part of the glass panel 12, which may cause distortion inside the glass and also cause thermal cracking.

Returning to Fig. 1, the functions of the window film 11 according to the first embodiment will be described. The solar light incident on the exposed portion of the glass panel 12 is partially transmitted to the indoor side, partially reflected by the glass panel 12, and partially absorbed into the glass panel 12. The heat in the glass panel 12 is absorbed by the heat-absorbing layer 22 and radiated from the heat-absorbing layer 22 to the indoor side through the protection layer 24, which has high emissivity. Also, near-infrared light and mid-infrared light incident on the glass panel 12 penetrates the heat-absorbing layer 22 and is partially absorbed by the heat-absorbing layer 22 to be radiated to the indoor side through the protection layer 24 with high emissivity. Furthermore, in the window film 11, when the solar cell layer 20 having wavelength sensitivity in the near-infrared wavelength band is employed, the near-infrared light is converted into electricity in the solar cell layer 20 and consumed. Accordingly, the temperature difference between the exposed portion and the unexposed portion in the outer circumference part of the glass panel 12 is smaller than in the case of the comparative example. As a result, thermal cracking can be suppressed.

Also, with the window film 11 according to the first embodiment, near-infrared light is converted into electricity in the solar cell layer 20 and consumed. Accordingly, the near-infrared light component transmitted to the indoor side and the heat radiated to the indoor side can be reduced, enhancing the thermal insulation and heat shielding effect. Furthermore, with the window film 11 according to the first embodiment, the electricity generated in the solar cell layer 20 can be used.

The same is true when the solar cell layer 20 having wavelength sensitivity in the near-infrared and mid-infrared wavelength bands is employed. Since near-infrared light and mid-infrared light is converted into electricity in the solar cell layer 20 and consumed, heat absorption due to reflection to the glass panel 12 can be suppressed. Accordingly, the temperature difference between the exposed portion and the unexposed portion of the glass panel 12 can be made smaller, and thermal cracking can be suppressed.

### Second Embodiment

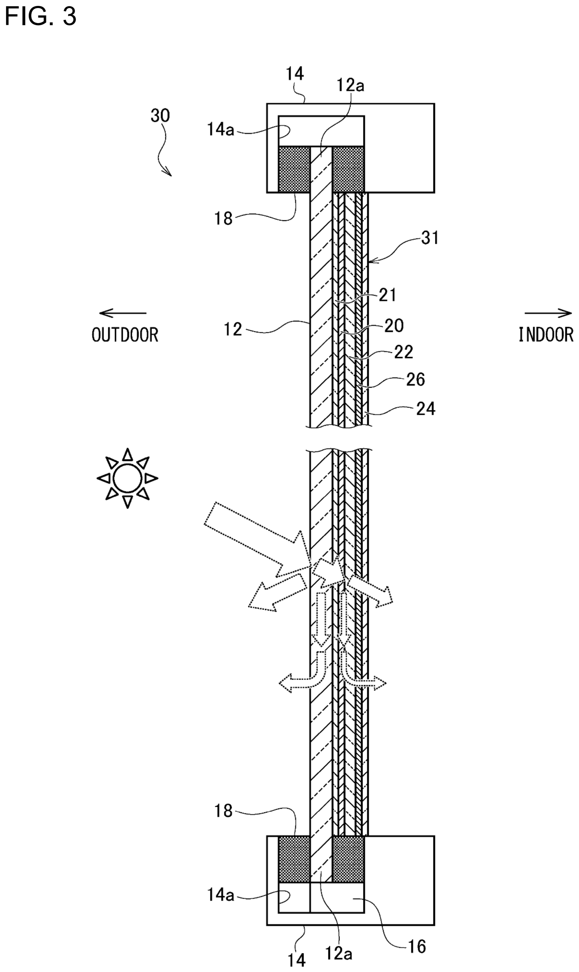

Fig. 3 is a schematic sectional view of a glass window 30 to which a window film 31 according to the second embodiment is affixed. The window film 31 differs from the window film 11 according to the first embodiment (see Fig. 1) in further including a second solar cell layer 26 that has wavelength sensitivity different from that of the solar cell layer (which will be referred to as the first solar cell layer) 20, between the heat-absorbing layer 22 and the protection layer 24. In the window film 31, the glass-side protection layer 21, the first solar cell layer 20, the heat-absorbing layer 22, the second solar cell layer 26, and the protection layer 24 are laminated in this order from the glass panel 12 side.

The first solar cell layer 20 may have wavelength sensitivity in a range of the near-infrared wavelength band, and the second solar cell layer 26 may have wavelength sensitivity in a range of the near-infrared and mid-infrared wavelength bands. Alternatively, the first solar cell layer 20 may have wavelength sensitivity in a range of the near-infrared and mid-infrared wavelength bands, and the second solar cell layer 26 may have wavelength sensitivity in a range of the near-infrared wavelength band.

With the window film 31 according to the second embodiment, since the solar cell layer 20 and the second solar cell layer 26 are provided, near-infrared light and mid-infrared light is converted into electricity and consumed. Accordingly, the temperature difference between the exposed portion and the unexposed portion of the glass panel 12 can be made further smaller compared to the window film 11 according to the first embodiment. Therefore, thermal cracking can be suppressed more effectively. Also, since the heat radiated to the indoor side can be further reduced compared to the window film 11 according to the first embodiment, the thermal insulation and heat shielding effect can be further enhanced. In addition, since near-infrared light and mid-infrared light can be converted into electricity, the electric-generating capacity can be increased.

### Third Embodiment

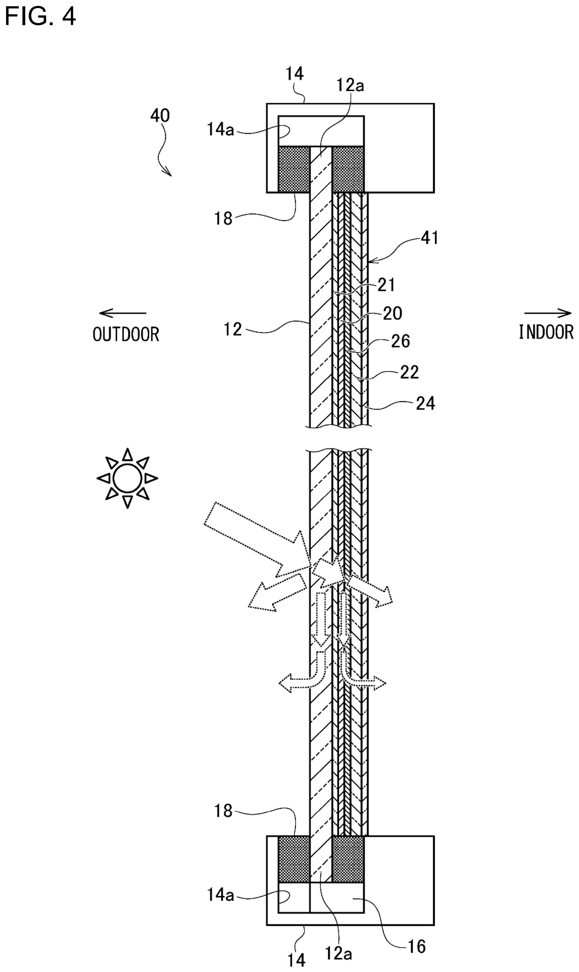

Fig. 4 is a schematic sectional view of a glass window 40 to which a window film 41 according to the third embodiment is affixed. The window film 41 differs from the window film 11 according to the first embodiment (see Fig. 1) in further including, between the solar cell layer (which will be referred to as the first solar cell layer) 20 and the heat-absorbing layer 22, a second solar cell layer 26 that has wavelength sensitivity different from that of the first solar cell layer 20. In the window film 41, the glass-side protection layer 21, the first solar cell layer 20, the second solar cell layer 26, the heat-absorbing layer 22, and the protection layer 24 are laminated in this order from the glass panel 12 side.

The first solar cell layer 20 may have wavelength sensitivity in a range of the near-infrared wavelength band, and the second solar cell layer 26 may have wavelength sensitivity in a range of the near-infrared and mid-infrared wavelength bands. Alternatively, the first solar cell layer 20 may have wavelength sensitivity in the infrared wavelength band, and the second solar cell layer 26 may have wavelength sensitivity in the near-infrared wavelength band.

With the window film 31 according to the third embodiment, since the solar cell layer 20 and the second solar cell layer 26 are provided, near-infrared light and mid-infrared light is converted into electricity and consumed. Accordingly, the temperature difference between the exposed portion and the unexposed portion of the glass panel 12 can be made further smaller compared to the window film 11 according to the first embodiment. Therefore, thermal cracking can be suppressed more effectively. Also, since the heat radiated to the indoor side can be further reduced compared to the window film 11 according to the first embodiment, the thermal insulation and heat shielding effect can be further enhanced. In addition, since near-infrared light and mid-infrared light can be converted into electricity, the electric-generating capacity can be increased.

The solar cell layer 20 and the second solar cell layer 26 may be formed integrally or may be laminated. When the second solar cell layer 26 has wavelength sensitivity in the near-infrared and mid-infrared wavelength bands, the second solar cell layer 26 may be of bifacial type. In this case, since the near-infrared light and mid-infrared light absorbed in the heat-absorbing layer 22 can be used to generate electricity, thermal cracking can be suppressed more effectively, and the thermal insulation and heat shielding effect can be enhanced.

### Fourth Embodiment

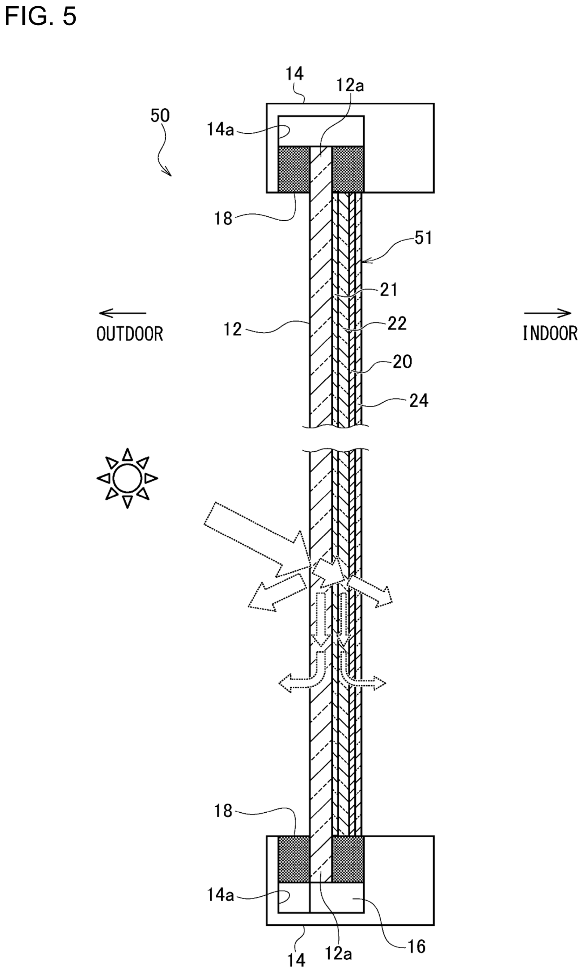

Fig. 5 is a schematic sectional view of a glass window 50 to which a window film 51 according to the fourth embodiment is affixed.

The window film 51 is affixed to the exposed surface of the glass panel 12 on the indoor side. In the window film 11, the glass-side protection layer 21, the heat-absorbing layer 22, the solar cell layer 20, and the protection layer 24 are laminated in this order from the glass panel 12 side. The protection layer 24 is disposed as the top surface of the window film 51. The laminating order of the glass-side protection layer 21 and the heat-absorbing layer 22 may be reversed.

The solar cell layer 20 may be a transparent solar cell layer (high transmittance to visible light) having wavelength sensitivity in a range of the near-infrared wavelength band (e.g., 780 nm to 1200 nm). Alternatively, the solar cell layer 20 may be a transparent solar cell layer (high transmittance to visible light) having wavelength sensitivity in a range of the near-infrared and mid-infrared wavelength bands (e.g., 1400 nm to 4000 nm).

The functions of the window film 51 according to the fourth embodiment will be described. The solar light incident on the exposed portion of the glass panel 12 is partially transmitted to the indoor side, partially reflected by the glass panel 12, and partially absorbed into the glass panel 12. The heat in the glass panel 12 is absorbed by the heat-absorbing layer 22 and radiated from the heat-absorbing layer 22 to the indoor side through the protection layer 24, which has high emissivity. Also, near-infrared light and mid-infrared light incident on the glass panel 12 penetrates the heat-absorbing layer 22 and is partially absorbed by the heat-absorbing layer 22 to be radiated to the indoor side through the protection layer 24 with high emissivity. Furthermore, in the window film 51, when the solar cell layer 20 having wavelength sensitivity in the near-infrared wavelength band is employed, the near-infrared light is converted into electricity in the solar cell layer 20 and consumed. Accordingly, the temperature difference between the exposed portion and the unexposed portion in the outer circumference part of the glass panel 12 is smaller than in the case of the comparative example (see Fig. 2). As a result, thermal cracking can be suppressed.

Also, with the window film 51 according to the fourth embodiment, near-infrared light is converted into electricity in the solar cell layer 20 and consumed. Accordingly, the heat radiated to the indoor side can be reduced, enhancing the thermal insulation and heat shielding effect. Furthermore, with the window film 11 according to the fourth embodiment, the electricity generated in the solar cell layer 20 can be used.

The same is true when the solar cell layer 20 having wavelength sensitivity in the near-infrared and mid-infrared wavelength bands is employed. Since near-infrared light and mid-infrared light is converted into electricity in the solar cell layer 20 and consumed, the temperature difference between the exposed portion and the unexposed portion of the glass panel 12 can be made smaller, and thermal cracking can be suppressed.

### Fifth Embodiment

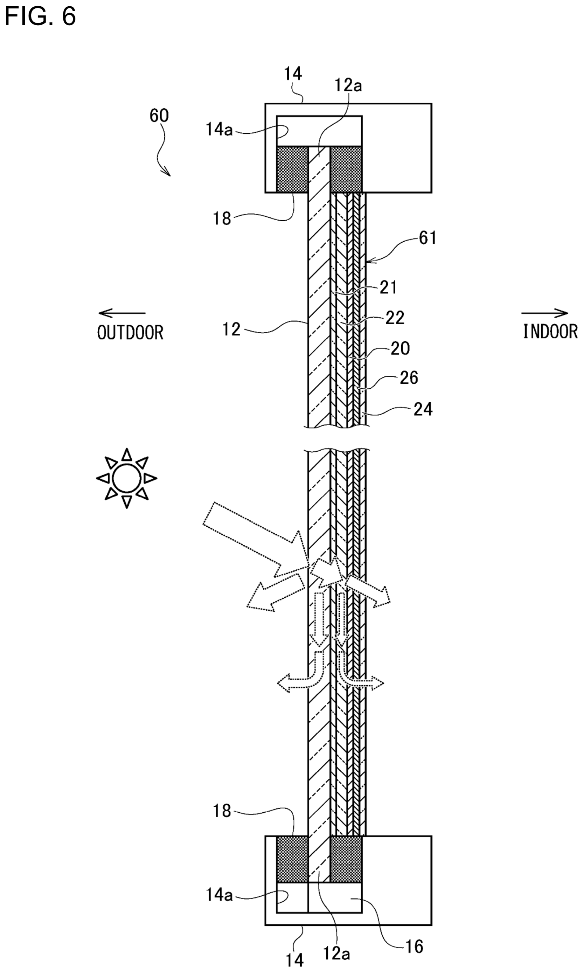

Fig. 6 is a schematic sectional view of a glass window 60 to which a window film 61 according to the fifth embodiment is affixed. The window film 61 differs from the window film 51 according to the fourth embodiment (see Fig. 5) in further including, between the solar cell layer (which will be referred to as the first solar cell layer) 20 and the protection layer 24, a second solar cell layer 26 that has wavelength sensitivity different from that of the first solar cell layer 20. In the window film 61, the glass-side protection layer 21, the heat-absorbing layer 22, the first solar cell layer 20, the second solar cell layer 26, and the protection layer 24 are laminated in this order from the glass panel 12 side. The laminating order of the glass-side protection layer 21 and the heat-absorbing layer 22 may be reversed.

The first solar cell layer 20 may have wavelength sensitivity in a range of the near-infrared wavelength band, and the second solar cell layer 26 may have wavelength sensitivity in a range of the near-infrared and mid-infrared wavelength bands. Alternatively, the first solar cell layer 20 may have wavelength sensitivity in a range of the near-infrared and mid-infrared wavelength bands, and the second solar cell layer 26 may have wavelength sensitivity in a range of the near-infrared wavelength band.

With the window film 61 according to the fifth embodiment, since the solar cell layer 20 and the second solar cell layer 26 are provided, near-infrared light and mid-infrared light is converted into electricity and consumed. Accordingly, the temperature difference between the exposed portion and the unexposed portion of the glass panel 12 can be made further smaller compared to the window film 51 according to the fourth embodiment. Therefore, thermal cracking can be suppressed more effectively. Also, since the heat radiated to the indoor side can be further reduced compared to the window film 51 according to the fourth embodiment, the thermal insulation and heat shielding effect can be further enhanced. In addition, since near-infrared light and infrared light can be converted into electricity, the electric-generating capacity can be increased.

The present invention has been described with reference to embodiments. The embodiments are intended to be illustrative only, and it will be obvious to those skilled in the art that various modifications and changes could be developed within the scope of claims of the present invention and that such modifications and changes also fall within the scope of claims of the present invention. Therefore, the description in the present specification and the drawings should be regarded as illustrative rather than limitative.

For example, although the above describes an embodiment in which a window film is affixed to single-glazed glass, the window film may be affixed to the hollow layer side of the outer glass, the hollow layer side of the inner glass, or the indoor side surface of the indoor glass of multi-glazed glass.

### INDUSTRIAL APPLICABILITY

The present invention is applicable to window films that are affixed to glass panels.

### REFERENCE SIGNS LIST

10, 30, 40, 50 glass window, 11, 31, 41, 51, 61 window film, 12 glass panel, 14 frame, 20 solar cell layer, 22 heat-absorbing layer, 24 protection layer, 26 second solar cell layer

## Claims

1. A window film affixed onto a glass panel, the window film comprising:
a solar cell layer;
a heat-absorbing layer that absorbs heat from the glass panel; and
a protection layer disposed as a top surface.

2. The window film according to Claim 1, wherein the solar cell layer has wavelength sensitivity in a range of a near-infrared wavelength band or in a range of near-infrared and mid-infrared wavelength bands.

3. The window film according to Claim 1 or 2, further comprising a second solar cell layer that has wavelength sensitivity different from the wavelength sensitivity of the solar cell layer.

4. The window film according to Claim 3,
wherein the solar cell layer has wavelength sensitivity in one of a range of a near-infrared wavelength band or a range of near-infrared and mid-infrared wavelength bands, and
wherein the second solar cell layer has wavelength sensitivity in the other of the range of the near-infrared wavelength band or the range of the near-infrared and mid-infrared wavelength bands.

5. The window film according to Claim 1 or 2, wherein the solar cell layer, the heat-absorbing layer, and the protection layer are laminated in this order from the glass panel side.

6. The window film according to Claim 3 or 4, wherein the solar cell layer, the heat-absorbing layer, the second solar cell layer, and the protection layer are laminated in this order from the glass panel side.

7. The window film according to Claim 3 or 4, wherein the solar cell layer, the second solar cell layer, the heat-absorbing layer, and the protection layer are laminated in this order from the glass panel side.

8. The window film according to Claim 1 or 2, wherein the heat-absorbing layer, the solar cell layer, and the protection layer are laminated in this order from the glass panel side.

9. The window film according to Claim 3 or 4, wherein the heat-absorbing layer, the solar cell layer, the second solar cell layer, and the protection layer are laminated in this order from the glass panel side.

10. A glass window, comprising:
a glass panel;
a frame that supports an outer circumferential edge of the glass panel; and
the window film according to any one of Claims 1 through 9 affixed onto an exposed surface of the glass panel.
